# EUROPEAN PATENT SPECIFICATION

(11) **EP 2 752 872 B1**
(45) Date of publication and mention of the grant of the patent: **27.06.2018**
(21) Application number: 14163096.2
(22) Date of filing: 31.07.2008
(51) Int. Cl.: H01L 23/552

(54) **Semiconductor package with integrated interference shielding and method of manufacture thereof**
Halbleiterpaket mit integrierter Interferenzabschirmung und Verfahren zu seiner Herstellung
Boîtier semi-conducteur doté d'un blindage contre les interférences intégré et procédé de fabrication de celui-ci

(43) Date of publication of application: 09.07.2014
(62) Divisional of application: 08796999.4
(73) Proprietor: Skyworks Solutions, Inc., Woburn, MA 01801 (US)
(72) Inventor: Welch, Patrick, Laguna Niguel, CA 92677 (US); Guo, Yifan, Aliso Viejo, CA 92656 (US)
(74) Representative: Lloyd, Patrick Alexander Desmond

(56) References cited:
- JP-A- 2003 086 621
- JP-A- 2003 163 314
- US-A1- 2007 241 440
- US-B1- 7 084 656

## Description

### BACKGROUND

### Field of Invention

The present invention is directed to semiconductor device packages and, more particularly, to electromagnetic and/or radio frequency interference shielding for semiconductor devices.

### Discussion of Related Art

There exists a general need in radio frequency (RF) communication systems for RF devices to be isolated from electromagnetic (radio frequency) interference (EMI) generated by other RF devices in order to maintain proper device performance. Similarly, the RF devices generally need to be isolated from the electromagnetic interference received from, or transmitted to, the environment.

The traditional method of isolating RF devices from such electromagnetic interference is to cover the RF device with a grounded metal enclosure typically called a "can." However, this solution is costly and lacks design flexibility. In addition, the metal can adds significant size to the device footprint on a printed circuit board, and also adds weight to the printed circuit board.

US 2007/0241440 relates to an over-molded semiconductor package with a wirebond loop cage and a conductive layer connected to the wirebond loop cage to form an EMI shield. US 7084656 describes improved probe interconnections for attaching directly to active silicon devices. JP 2003-086621 relates to improving the connection stability of a substrate and a semiconductor device.

### SUMMARY

Aspects and embodiments of the present invention are directed to a semiconductor device package, and methods of making the same, that uses wirebond process technologies to integrate an electromagnetic interference shield into the device package. In one embodiment, wirebond processes are used to form wirebond springs that are positioned around the device and coupled to conductive layers above and below the device, thereby forming an electromagnetic interference shield around the device. As discussed further below, the shape of and spring effect created by the wirebond springs enable a robust manufacturing process to create reliable electrical connections between a conductive layer at the top of the molded package and a ground plane in the substrate of the package. The use of these wirebond springs provides a flexible solution for integrated electromagnetic interference shielding that may be applied to any over-molded device.

One aspect is directed to a packaged semiconductor module having an integrated electromagnetic interference shield. In one embodiment, the packaged semiconductor module comprises a substrate having a ground plane; an electronic device mounted on a surface of the substrate; a plurality of wirebond springs disposed about the electronic device and electrically coupled to the ground plane, each of the plurality of wirebond springs including a loop of wire having at a first end a ball bond disposed on the surface of the substrate, a zone of inflection, a crest substantially vertically above the zone of inflection, a convex region extending between the zone of inflection and the crest, the zone of inflection being between the convex region and the ball bond, a sloping tail region having an end coupled to the substrate, said sloping tail region's end forming the second end of said loop of wire, and a substantially flat region extending between the crest and the sloping tail region; a mold compound covering the electronic device and at least partially covering the plurality of wirebond springs; and a conductive layer disposed on a top surface of the mold compound and electrically coupled to at least some of the plurality of wirebond springs, the plurality of wirebond springs, the conductive layer and the ground plane together forming the integrated electromagnetic interference shield.

In one example, the conductive layer comprises silver-filled epoxy. The wirebond springs can be made from various conductive materials, such as gold wire or copper wire. Each of the plurality of wirebond springs may comprise a continuous loop of wire shaped to provide a spring effect that permits contact between the conductive layer and the wirebond spring to provide the electrical coupling between the conductive layer and the wirebond spring. In one example, the electronic device is an RF device. The crest is substantially vertically above the zone of inflection. As discussed above, the wirebond spring may be formed from a variety of conductive materials, including gold wire or copper wire. In one example, wirebond springs having this structure are used in the semiconductor module discussed above.

Another aspect is directed to a method of manufacturing a module having an integrated electromagnetic interference shield. According to one embodiment, the method comprises connecting an electronic device to a substrate, providing metallizations on the substrate, forming a plurality of wirebond springs connected to the metallizations, each wirebond spring being formed by depositing a wire ball on the metallizations, forming a wire loop by drawing wire from the wire ball to form the wire loop having a first end connected to the wire ball, a zone of inflection, a crest substantially vertically above the zone of inflection, a convex region extending between the zone of inflection and the crest, the zone of inflection being between the convex region and the ball bond, a sloping tail region having an end connected to the metallizations, said end of said sloping tail region forming the second end of said wire loop, and a substantially flat region extending between the crest and the sloping tail region, performing a transfer molding process to encapsulate the electronic device in mold compound and to at least partially cover the plurality of wirebond springs with the mold compound, and disposing a conductive layer on a surface of the mold compound, the conductive layer electrically connected to at least some of the plurality of wirebond springs. In one example, the method further comprises ablating the surface of the mold compound, prior to disposing the conductive layer on the surface of the mold compound, to expose regions of at least some of the plurality of wirebond springs. In another example, providing metallizations includes providing a ground plane and at least one wirebond contact area electrically connected to the ground plane. In an example, disposing the conductive layer on the surface of the mold compound includes painting a layer of silver-filled epoxy on the surface of the mold compound.

Still other aspects, embodiments, and advantages of these exemplary aspects and embodiments, are discussed in detail below. Moreover, it is to be understood that both the foregoing information and the following detailed description are merely illustrative examples of various aspects and embodiments, and are intended to provide an overview or framework for understanding the nature and character of the claimed aspects and embodiments. Any embodiment disclosed herein may be combined with any other embodiment in any manner consistent with the objects, aims, and needs disclosed herein, and references to "an embodiment," "some embodiments," "an alternate embodiment," "various embodiments," "one embodiment" or the like are not necessarily mutually exclusive and are intended to indicate that a particular feature, structure, or characteristic described in connection with the embodiment may be included in at least one embodiment. The appearances of such terms herein are not necessarily all referring to the same embodiment. The accompanying drawings are included to provide illustration and a further understanding of the various aspects and embodiments, and are incorporated in and constitute a part of this specification. The drawings, together with the remainder of the specification, serve to explain principles and operations of the described and claimed aspects and embodiments.

### BRIEF DESCRIPTION OF THE DRAWINGS

Various aspects of at least one embodiment are discussed below with reference to the accompanying figures, which are not intended to be drawn to scale. Where technical features in the figures, detailed description or any claim are followed by references signs, the reference signs have been included for the sole purpose of increasing the intelligibility of the figures, detailed description, and claims. Accordingly, neither the reference signs nor their absence are intended to have any limiting effect on the scope of any claim elements. In the figures, each identical or nearly identical component that is illustrated in various figures is represented by a like numeral. For purposes of clarity, not every component may be labeled in every figure. The figures are provided for the purposes of illustration and explanation and are not intended as a definition of the limits of the invention. In the figures:
FIG. 1 is a flow diagram illustrating one example of a method of providing an integrated EMI shield as part of a packaging process, according to aspects of the invention;
FIG. 2 is a diagram of one example of an electronic module comprising a substrate and one or more dies mounted thereto;
FIG. 3 is a diagram of one example of a device package incorporating an integrated EMI shield according to aspects of the invention;
FIG. 4A is a diagram of another example of a device package incorporating an integrated EMI shield according to aspects of the invention;
FIG. 4B is a plan view of a portion of a device package illustrating a continuous wirebond track according to aspects of the invention;
FIG. 5 is an illustration of one example of a wirebond spring;
FIG. 6 is a flow diagram illustrating one example of a method of forming a wirebond spring;
FIG. 7 is a diagram of one example of a wirebond spring;
FIG. 8 is a diagram illustrating deformation of a wirebond spring during the transfer molding process, according to aspects of the invention;
FIG. 9 is an image of one example of a wirebond spring incorporated in a device package according to aspects of the invention; and
FIG. 10 is a plan view image of one example of a wirebond spring according to aspects of the invention.

### DETAILED DESCRIPTION

In many modern applications, including cellular phone handsets, personal digital assistants (PDAs), media players, and other portable device that use radio frequency (RF) components, the size (length, width and thickness) and weight of the finished product can often be critical design parameters. For example, particularly for cellular phone handsets, there is continuing drive toward smaller and lighter devices that offer increased functionality and features. Accordingly, the size and weight of individual components used in these devices can also be important. As discussed above, the conventional approach for providing electromagnetic interference shielding for RF devices involves placing a grounded metal can over the individual RF device to be shielded, which adds size, weight and cost to the design and therefore, may be undesirable in many applications.

Aspects and embodiments are directed to methods and apparatuses to provide an interference shield that is integrated into individual devices or modules during the packaging process with minimal increase in the size and/or weight of the device or module. As used herein, the term "EMI shield" is used to refer to both electromagnetic interference and radio frequency interference shielding. In one embodiment, an integrated EMI shield can be formed using wirebond manufacturing processes, as discussed further below, and therefore, can be manufactured using existing tools and assembled on a common processing line with conventional wirebonds used to provide electrical connections to electronic devices in the module. This approach may provide high design flexibility as well as an easier and less expensive method by which to manufacture EMI shields. In addition, an integrated "wirebond cage" shield according to aspects of the invention provides a way to achieve inter/intra module isolation and low package profile, which has not been achieved by conventional existing technologies. As discussed below, a wirebond cage may be formed using "wirebond spring" connectors having a particular and well-controlled design and shape to provide a robust and practical EMI shield for various packages and process conditions.

It is to be appreciated that embodiments of the methods and apparatuses discussed herein are not limited in application to the details of construction and the arrangement of components set forth in the following description or illustrated in the accompanying drawings. The methods and apparatuses are capable of implementation in other embodiments and of being practiced or of being carried out in various ways. Examples of specific implementations are provided herein for illustrative purposes only and are not intended to be limiting. In particular, acts, elements and features discussed in connection with any one or more embodiments are not intended to be excluded from a similar role in any other embodiments. Also, the phraseology and terminology used herein is for the purpose of description and should not be regarded as limiting. Any references to embodiments or elements or acts of the systems and methods herein referred to in the singular may also embrace embodiments including a plurality of these elements, and any references in plural to any embodiment or element or act herein may also embrace embodiments including only a single element. References in the singular or plural form are not intended to limit the presently disclosed systems or methods, their components, acts, or elements. The use herein of "including," "comprising," "having," "containing," "involving," and variations thereof is meant to encompass the items listed thereafter as well as additional items. References to "or" may be construed as inclusive so that any terms described using "or" may indicate any of a single, more than one, and all of the described terms. Any references to front and back, left and right, top and bottom, and upper and lower are intended for convenience of description, not to limit the present systems and methods or their components to any one positional or spatial orientation.

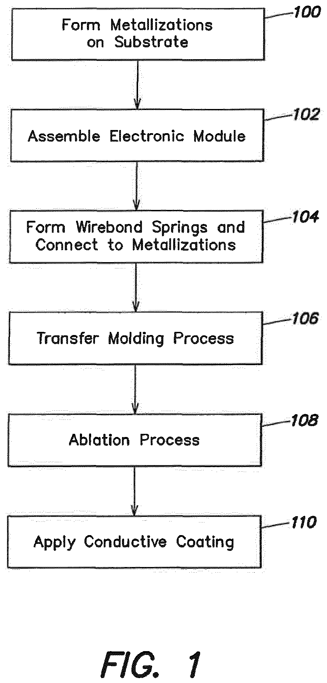

Referring to FIG. 1, there is illustrated one example of a method of packaging an electronic device or module incorporating an integrated EMI shield, in accordance with aspects of the invention. Aspects and embodiments of the method are discussed below with continuing reference to FIG. 1.

A first step 100 includes preparing a substrate to be incorporated into an electronic module. This step 100 includes forming metallizations on the substrate that may be used to interconnect various components of the electronic module and at least some of which may become part of the integrated EMI shield, as discussed further below. In step 102, an electronic module may be assembled according to methods and techniques known to those skilled in the art. This step 102 may include acts such as mounting one or more dies to the substrate, forming any necessary internal or external connections or connection points (including depositing layers of metallization and/or dielectric), etc. Therefore, it is to be appreciated that although module assembly is illustrated as a single step 102 in FIG. 1, it may comprise several steps that may be performed at the same time, at different times, and/or in different locations. Furthermore, it is to be appreciated that step 100 may be considered part of step 102.

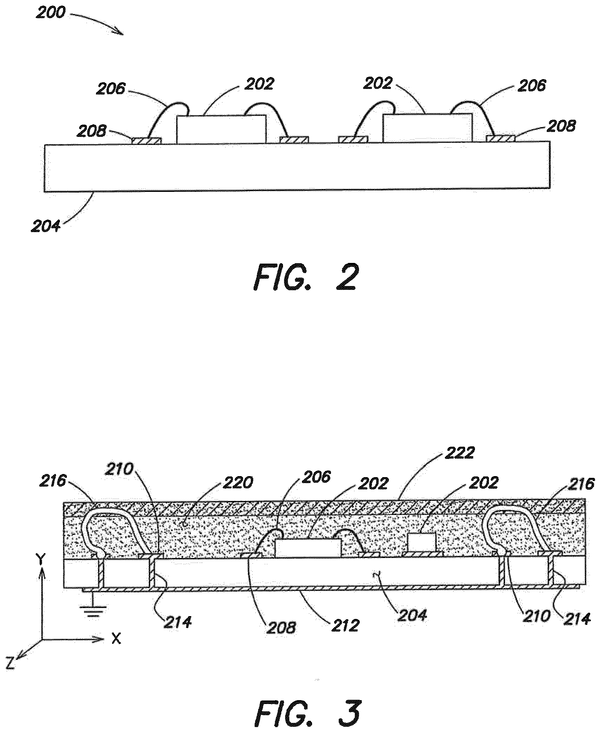

An example of such a module is illustrated in FIG. 2. The module 200 comprises one or more dies 202 mounted to a substrate 204. Some examples of the module 200 include, but are not limited to, power amplifiers, transceivers, linear devices, filters and other devices that may require or benefit from EMI shielding. As discussed above, EMI shielding is typically desirable for RF devices and therefore, at least one of the dies 202 may be an RF device and the module 200 may be an RF module; however, it is to be appreciated that the invention is not so limited, and the dies 202 may comprise any type of digital or analog device or component. In one example, the dies 202 are mounted to the substrate 204 using wire bonds 206 connected to bond pads 208, as illustrated in FIG. 2. Alternatively, the dies 202 may be mounted to the substrate 204 using flip chip bonding methods, or any other suitable technique known to those skilled in the art.

According to one embodiment, an integrated EMI shield is incorporated into the module 200 by constructing a wirebond cage around the edges of the substrate 204 during the packaging process. A wirebond process similar to the conventional process used to form wirebonds 206 and using the same equipment may be implemented to construct a wirebond spring, as discussed below. A plurality of these wirebond springs may be placed around the die(s) 202 on the substrate 204 and connected to ground planes in the package, as discussed further below, to provide a wirebond spring cage that forms the integrated EMI shield. To form an integrated shield in a molded module, a manufacturing difficulty lies in finding a way to connect the ground plane in the substrate to the top conductive shield layer. Embodiments of the methods of forming an integrated shield using wirebond spring connectors provide a robust manufacturing process for resolving this difficulty, as discussed further below.

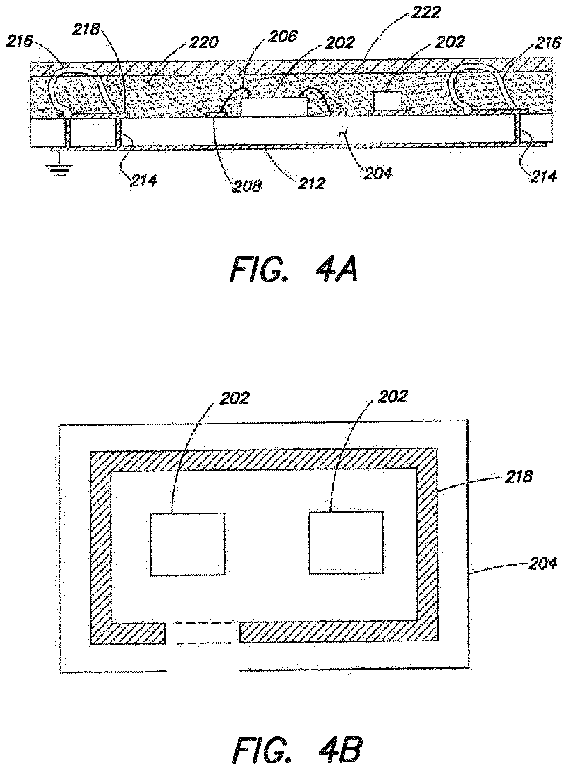

Referring again to FIG. 1, as discussed above, step 100 includes forming metallizations on the substrate 204 that will become part of the integrated EMI shield. Referring to FIG. 3, these metallizations may include wirebond pads 210, a ground plane 212, and vias 214 that connect the wirebond pads to the ground plane. Wirebond springs 216 may then be connected to the wirebond pads 210 (step 104), as discussed further below. It is to be appreciated that although in the example illustrated in FIG. 3, two discrete wirebond pads 210, with associated vias 214, are provided for each wirebond spring 216, the invention is not so limited and many other configurations are contemplated. For example, as illustrated in FIGS. 4A and 4B, the individual wirebond pads 210 may be replaced with a metallization track or ring 218 that may at least partially encircle the die(s) 202. In this example, one or more vias 214 may be provided at points along the track 218 to couple the track, and therefore the wirebond springs 216, to the ground plane 212. Furthermore, in one example, the track 218 may be continuous between two or more wirebond springs 216 and therefore, each wirebond spring need not have an individually associated via 214. In addition, although in FIG. 3, the wirebond spring 216 is illustrated with both connection points (at wirebond pads 210) coupled to the ground plane 212 by vias 214, this need not be the case, and one of the ends of the wirebond springs may be left floating (i.e., not electrically coupled to the ground plane). The method of forming an integrated EMI shield includes a transfer molding process (step 106) to encapsulate the die(s) 202 in a mold compound 220. As discussed further below, during the transfer molding process the substrate 204 is placed in a lower mold chase, an upper mold chase is lowered onto the lower mold chase to a seal a cavity around the device, and the mold compound 220 is flowed into the cavity to encapsulate the die(s) 202 on the substrate. Transfer molding processes are well known to those skilled in the art.

Still referring to FIGS. 1 and 3, after the transfer molding process (step 106), an ablation process (step 108) may be used to expose the tops of the wirebond springs 216 through the mold compound 220. The ablation process may include, for example, a laser ablation process, grinding and/or polishing the mold compound 220 to remove a layer of mold compound and expose the tops of the wirebond springs 216. In one example, the ablation process may remove a layer of mold compound that is less than about 40 microns thick, In another example, the ablation process may remove a layer of mold compound that is about 10 microns thick. After the tops of the wirebond springs 216 have been exposed, a thin conductive coating or layer 222 is formed on top of the mold compound 220 (step 110) to contact the exposed tops of the wirebond springs 216. The conductive layer 222 may be deposited on top of the mold compound 220 using any of various techniques known to those skilled in the art, such as, by printing, depositing, sputtering, etc. In one example, the conductive layer 222 comprises a metal-filled epoxy, such as a silver-filled epoxy, that is spray-painted on top of the mold compound 220. The conductive layer 222 contacts the exposed tops of the wirebond springs 216 and thus electrically connects the exposed wirebond springs.

As discussed above, the module 200 includes a ground plane 212 disposed along a bottom surface of the substrate 204, as shown in FIG. 3, and connected to the wirebond springs 216 by vias 214. Through contact between the tops of the wirebond springs 216 and the conductive layer 222, an electrical connection is formed between the conductive layer and the ground plane 212, thus completing an EMI shield in the module 200. The wirebond springs 216 provide a flexible (because they may be located anywhere suitable on the substrate) and fully integrated connection between the ground plane 212 in the substrate 204 and the top conductive shield layer 222. The wirebond springs 216 have a defined shape, as discussed further below, which is controlled to produce a spring effect that facilitates creating reliable electrical connections between the wirebond springs and the conductive layer 222. Thus, one or more of the die(s) 202 may be substantially enclosed in a grounded EMI shield formed by the conductive layer 222, the wirebond springs 216 (and their associated metallizations, such as vias 214 and bond pads 210) and the ground plane 212. This integrated EMI shield according to embodiments of the invention may add minimal size and weight to the module 200, unlike the bulky metal cans of conventional EMI shielding solutions. The wirebond springs 216 have a particular shape and height that are well controlled and substantially different from conventional wirebonds 206. As known to those skilled in the art, conventional wirebonds 206 are formed, using a wirebonding machine, by connecting one end of a bond wire to the die 202 and controlling the movement of the wirebonding machine to draw the bond wire away from the die to form a loop, as illustrated in FIGS. 2 and 3, and then connecting the other end of the bond wire to a pad on the substrate. The wirebond springs 216 according to embodiments of the invention may be formed using a similar technique, but the wire loop is processed, by manipulating x-axis and y-axis motion of the wirebonding machine, to a unique shape that provides the desired spring effect and other properties of the wirebond spring discussed below.

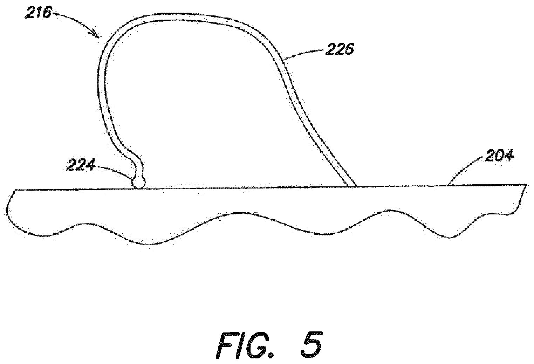

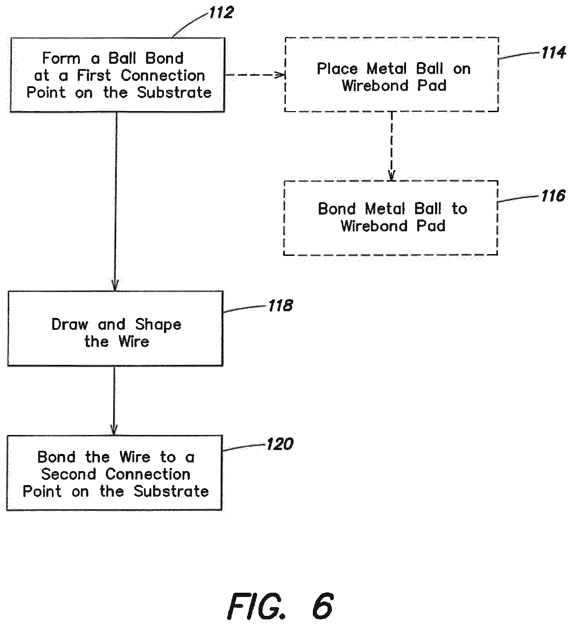

Referring to FIG. 5, there is illustrated one wirebond spring 216. The wirebond spring 216 comprises a ball bond 224, which provides a first connection point between the wirebond spring and the substrate 204, and a wire loop 226 extending from the ball bond to a second connection point 228 on the substrate. Referring to FIGS. 5 and 6, the process of forming the wirebond spring 216 (step 104) begins with a first step 112 of forming the ball bond 224. This step includes placing a metal ball on a wirebond pad 210 (see FIG. 3) on the substrate 204 (step 114) and bonding the ball to the wirebond pad (step 116) to form the ball bond 224. The wirebond spring may be formed using any of a variety of metals, including gold (as is commonly used for conventional wirebonds) and copper. In one example, in which the wirebond spring is made of gold, the wirebond pad 210 may similarly be gold, or gold-plated, and the ball bond 224 is ultrasonically bonded to the substrate 204. A similar thermosonic process may be used to form a copper ball bond 224 on gold, copper or tin-plated wirebond pads 210. The wire loop 226 is formed by drawing the wire from the ball bond 224, shaping the wire (step 118) by manipulating the x-axis and y-axis motion of the wirebonding machine, and finally bonding the tail end of the wire loop to the wirebond pad 210 (step 120). The wire loop 226 is shaped to have the shape illustrated in FIG. 5, or a shape similar thereto.

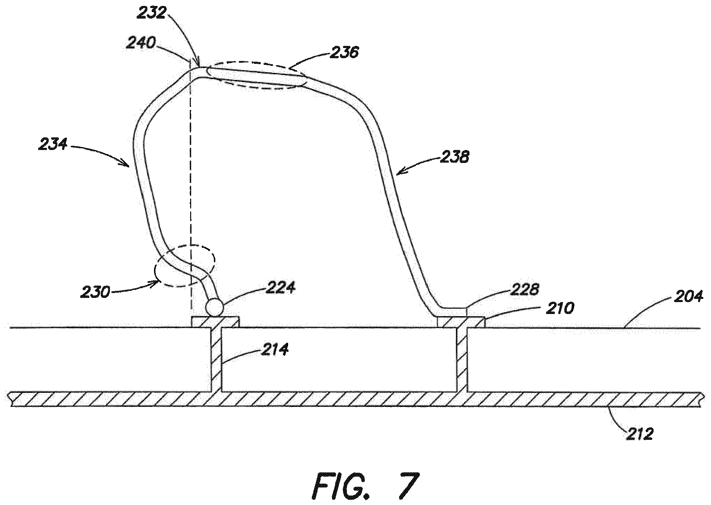

Referring to FIG. 7, there is illustrated a wirebond spring 216 bonded to wirebond pads 210 (or a track 218) provided on the substrate 204, as discussed above. The wirebond spring 216 comprises a zone of inflection 230 near the ball bond 224. The wire extends upwardly from the zone of inflection 230 to a crest 232 of the wirebond spring 216. A convex region 234 extends between the zone of inflection 230 and the crest 232. The wirebond spring 216 further comprises an upper region 236 proximate the crest 232 and a downward sloping tail region 238 that extends between the upper region 236 and the second connection point 228. The upper region 236 is substantially flat so as to provide a large contact area with the upper conductive layer 222 (see FIG. 4), thereby facilitating a good electrical connection with the conductive layer. The zone of inflection 230 is used to make the wirebond spring 216 more resilient, compared to a conventional wirebond, contributing the spring effect of the wirebond spring and the ability of the wirebond spring with withstand the pressure applied by the mold chase and mold compound and to retain its shape during the transfer molding process 106, as discussed further below. The crest 232 of the wirebond spring is positioned substantially over the zone of inflection 236, as indicated by dotted line 240, which may further contribute to the resiliency of the wirebond spring 216, as discussed below.

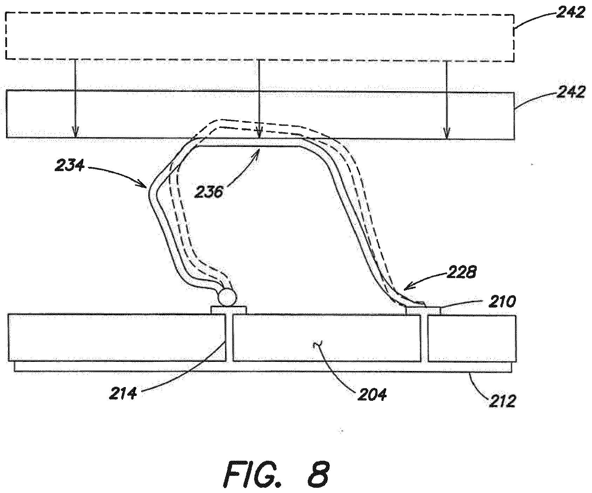

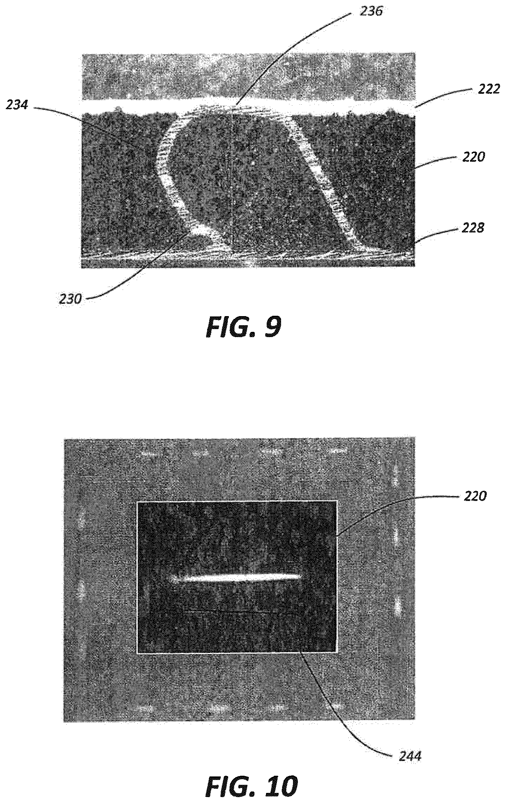

As known to those skilled in the art and discussed above, during the transfer molding process, the device is placed in a lower mold chase, an upper mold chase is lowered onto the lower mold chase to a seal a cavity around the device, and the mold compound 220 is flowed into the cavity. The height of the wirebond spring 216, measured from the wirebond pad 210 to the crest 232, may be made slightly taller than the expected or designed thickness of the mold compound 220. During the transfer molding process (step 106), the wirebond spring 216 is compressed by the descending upper mold chase 242, as illustrated in FIG. 8. In one example, the upper mold chase 242 first makes contact the crest 232 of the wirebond spring 216, as the crest is the highest point of the wirebond spring. Due to the spring constant of the wirebond spring 216, provided by the zone of inflection 230 and the positioning of the crest 232 substantially over the zone of inflection, the wirebond spring remains in contact with the surface of the upper mold chase 242, as illustrated in FIG. 8. This spring effect provided by the shape of the wirebond spring 216 enables robust manufacturing of the integrated EMI shield because by causing the top of the wirebond spring to remain in contact with the surface of the mold chase, only a thin layer of mold compound may cover the top of the wirebond spring, such that the top of the wirebond spring may be easily and reliably exposed following the ablation process (step 108). In one example, the wirebond spring 216 has a large spring range in the vertical direction and is able to absorb variations in finished height resulting from variations in the mold compound thickness, the substrate thickness and warpage that may occur during the transfer molding process. The height of the wirebond spring may be selected to be sufficiently high such that the wirebond spring is compressed when the upper mold chase 242 descends, but not so high that the descending upper mold chase crushes the wirebond spring. Thus, the wirebond spring should not be so high that the amount of deformation required to accommodate the descending upper mold chase 242 exceeds the spring capability of the wirebond spring. Similarly, the if the wirebond spring is not sufficiently high, the top of the wirebond spring may not contact or be sufficiently near the upper surface of the mold compound following the transfer molding process, and thus may not be exposed by the ablation process (step 108), or may not exhibit sufficient elastic deformation (spring effect) to hold the top of the wirebond spring in contact with the upper surface of the mold compound. In one example, the height of the wirebond spring 216 is about 90 microns taller than the designed thickness of the mold compound. However, it is to be appreciated that the wirebond spring may have a different height depending on factors such as, for example, the metal used to form the wirebond spring, the mold material, etc. The shape of the wirebond spring 216 is optimized to provide a large contact area with the conductive layer 222, thereby facilitating good electrical connection with the conductive layer 222. As discussed above, the upper region 236 of the wirebond spring 216 is substantially flat. Thus, when compressed by the upper mold chase 242, the upper region 236 may provide a large flat area (length) that is in contact with the mold chase (or surface of the mold compound). This is the area that will be exposed at the top of the package by the ablation step (step 108) and in contact with the conductive layer 222 to form an electrical connection with the conductive layer 222 and complete the EMI shield. Referring to FIG. 9, there is illustrated an image of one example of a wirebond spring incorporated in a device package. As illustrated in FIG. 9, the upper region 236 of the wirebond spring forms a large flat area on top of the mold compound 220 and in contact with the conductive layer 222. A plan view of the wirebond spring of FIG. 9 is illustrated in FIG. 10. Referring to FIG. 10, a long length 244 of exposed wire, predominantly, but not necessarily entirely, corresponding to the upper region 236 and crest 232 of the wirebond spring, can be seen on top of the mold compound 220. Manufactured and simulated examples of packages including wirebond springs have been created having an average exposure length 244 of about 400 microns, and a minimum exposure length of about 200 microns. These examples illustrate an improvement in the exposure length of the wire of about 10x compared to conventional wirebond loops (206 in FIG. 4A). This increased contact area provides a robust and low resistance electrical connection for the integrated EMI shield. Furthermore, if a material such as copper is used for the wirebond springs, rather than gold, for example to reduce cost, the large contact area may be particularly important as copper has a lower conductivity than does gold. In addition, as no solder is used to make the connection between the exposed region of the wirebond spring and the conductive layer 222, (the connection being made by the just contact between the two conductors), the larger the contact area, the more reliable the connection may be.

In addition to providing a spring effect and large contact area to facilitate a good and robust electrical connection with the conductive layer 222, the shape of the wirebond spring 216 also provide resiliency during the transfer molding process. Applicants have experimentally determined that it is important the wirebond springs remain upright during the transfer molding process so that the upper region is at or near the top of the mold compound and can be readily exposed with minimal ablation. Tests and simulations have demonstrated that conventionally-shaped wirebond loops fold and collapse during the transfer molding process because their shape provides little or no stability. As a result, the loops can move in any direction under pressure from the upper mold chase 242 and flowing mold compound. By contrast, the shape of the wirebond springs 216 controls movement of the wirebond spring to, predominantly, compression (elastic deformation) in the vertical direction (y-direction in FIG. 3), resulting in the spring effect discussed above. In one example, the wirebond springs are stiff in the in-plane direction (i.e., the x-z-direction in FIG. 3) and have good resistance to mold flow and wire sweep defects, which may be major concern with very high loops.

In summary, an effective, low cost and robust integrated EMI shield can be provided in any transfer molded module using only the ground plane typically already present in the module substrate, a thin layer of conductive material deposited on top of the mold compound, and a plurality of the wirebond springs discussed herein to connect the conductive layer to the ground plane, thereby forming a complete shield for some or all of the devices in the module. The wirebond springs may be placed anywhere in the package, with optional redundant connections to ensure the contact to the conductive layer 222 meets all electrical requirements, allowing for a very flexible EMI shield design that can be easily modified to accommodate different module layouts and devices. Similarly, as discussed above with reference to FIGS. 4A and 4B, the vias 214 connecting the wirebond pads 210 (or track 218) to the ground plane need not be coincident with each pad, or with specific locations on the ground plane, allowing for flexible pad 210 and via 214 placement in the module. The number of wirebond springs required to provide an adequate EMI shield depends on the operating frequency of the devices to be shielded and the level of shielding required. For example, the wire density (i.e., the spacing between immediately adjacent wirebond springs 216 in any given direction) may increase with increasing signal frequency. In one example, a wire spacing of about λ/20 (where λ is the wavelength of the signal to be shielded) may be used. It is to be appreciated that the wire spacing need not be uniform, provided only that the minimum spacing to achieve desired shielding at a given frequency is maintained. Examples of wirebond spring EMI cages were tested and found to provide approximately a 20 dB shield, which is presently sufficient for most RF handset applications. Thus, the wirebond springs discussed herein can be used to provide a completely integrated EMI shield that is highly flexible and adds minimal cost, weight and/or size to the module. The wirebond springs may be processed using traditional processing techniques which are low cost, robust and do not require the procurement of any additional or specialized assembly equipment.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the invention. Accordingly, the foregoing description and drawings are by way of example only, and the scope of the invention should be determined from proper construction of the appended claims.

## Claims

1. A packaged semiconductor module (200) having an integrated electromagnetic interference shield, the packaged semiconductor module (200) comprising:
a substrate (204) having a ground plane (212); an electronic device (202) mounted on a surface of the substrate (204);
a plurality of wirebond springs (216) disposed about the electronic device (202) and electrically coupled to the ground plane, each of the plurality of wirebond springs (216) including a loop of wire (226) having at a first end a ball bond (224) disposed on the surface of the substrate (204), a zone of inflection (230), a crest (232) substantially vertically above the zone of inflection (230), a convex region (234) extending between the zone of inflection (230) and the crest (232), the zone of inflection (230) being between the convex region (234) and the ball bond (224), a sloping tail region (238) having an end coupled to the substrate (204), said sloping tail region's end forming the second end of said loop of wire, and a substantially flat region (236) extending between the crest (232) and the sloping tail region (238);
a mold compound (220) covering the electronic device (202) and at least partially covering the plurality of wirebond springs (216); and
a conductive layer (222) disposed on a top surface of the mold compound (220) and electrically coupled to at least some of the plurality of wirebond springs (216), the plurality of wirebond springs (216), the conductive layer (222) and the ground plane together forming the integrated electromagnetic interference shield.

2. The packaged semiconductor module (200) as claimed in claim 1 wherein the plurality of wirebond springs (216) are formed from gold wire or copper wire.

3. The packaged semiconductor module (200) as claimed in any preceding claim wherein the conductive layer (222) includes silver- filled epoxy.

4. The packaged semiconductor module (200) as claimed in any preceding claim wherein the electronic device (202) is an RF device.

5. The packaged semiconductor module (200) as claimed in any preceding claim wherein each of the plurality of wirebond springs (216) is shaped to provide a spring effect that permits contact between the conductive layer (222) and the wirebond spring (216) to provide the electrical coupling between the conductive layer (222) and the wirebond spring (216).

6. The packaged semiconductor module (200) as claimed in any preceding claim further comprising first and second metallized connection points (214, 210) disposed on the surface of the substrate (204), the ball bond (224) being coupled to the first metallized connection point (214) and the end of the sloping tail region (238) being coupled to the second metallized connection point (210).

7. The packaged semiconductor module (200) as claimed in claim 1 wherein the plurality of wirebond springs (216) are positioned on the substrate (204) about a perimeter of the electronic device (202).

8. A method of manufacturing a module (200) having an integrated electromagnetic interference shield, the method comprising:
connecting an electronic device (202) to a substrate (204);
providing metallizations (214, 210) on the substrate (204);
forming a plurality of wirebond springs (216) connected to the metallizations (214, 210), each wirebond spring (216) being formed by depositing a wire ball (224) on the metallizations (214), forming a wire loop (226) by drawing wire from the wire ball (224) to form the wire loop (226) having a first end connected to the wire ball (224), a zone of inflection (230), a crest (232) substantially vertically above the zone of inflection (230), a convex region (234) extending between the zone of inflection (230) and the crest (232), the zone of inflection (230) being between the convex region (234) and the ball bond (224), a sloping tail region (238) having an end connected to the metallizations (210), said end of said sloping tail region forming the second end of said wire loop, and a substantially flat region (236) extending between the crest (232) and the sloping tail region (238);
performing a transfer molding process to encapsulate the electronic device (202) in mold compound (220) and to at least partially cover the plurality of wirebond springs (216) with the mold compound (220); and
disposing a conductive layer (222) on a surface of the mold compound (220), the conductive layer (222) being electrically connected to at least some of the plurality of wirebond springs (216).

9. The method as claimed in claim 8 further comprising ablating the surface of the mold compound (220), prior to disposing the conductive layer (222) on the surface of the mold compound (220), to expose regions of at least some of the plurality of wirebond springs (216).

10. The method as claimed in claim 8 wherein providing metallizations (214, 210) includes providing a ground plane and at least one wirebond contact area electrically connected to the ground plane.

11. The method as claimed in claim 8 wherein disposing the conductive layer (222) on the surface of the mold compound (220) includes painting a layer of silver-filled epoxy on the surface of the mold compound (220).

## Patentansprüche

1. Verpacktes Halbleitermodul (200) mit einer integrierten elektromagnetischen Störabschirmung, wobei das verpackte Halbleitermodul (200) Folgendes umfasst:
ein Substrat (204) mit einer Grundplatte (212);
ein elektronisches Bauelement (202), das auf einer Oberfläche des Substrats (204) montiert ist;
mehrere Drahtbondfedern (216), die um das elektronische Bauelement (202) herum angeordnet und mit der Grundplatte elektrisch gekoppelt sind, wobei jede der mehreren Drahtbondfedern (216) eine Drahtschlaufe (226) beinhaltet, an einem ersten Ende mit einem Kugelbond (224), angeordnet auf der Oberfläche des Substrats (204), einer Beugungszone (230), einem Scheitelpunkt (232) im Wesentlichen vertikal über der Beugungszone (230), einer konvexen Region (234), die zwischen der Beugungszone (230) und dem Scheitelpunkt (232) verläuft, wobei sich die Beugungszone (230) zwischen der konvexen Region (234) und dem Kugelbond (224) befindet, einer abfallenden Schweifregion (238) mit einem mit dem Substrat (204) gekoppelten Ende, wobei das Ende der genannten abfallenen Schweifregion das zweite Ende der genannten Drahtschlaufe bildet, und einer im Wesentlichen flachen Region (236), die zwischen dem Scheitelpunkt (232) und der abfallenden Schweifregion (238) verläuft;
eine Formmasse (220), die das elektronische Bauelement (202) bedeckt und die mehreren Drahtbondfedern (216) wenigstens teilweise bedeckt; und
eine leitende Schicht (222), die auf einer Oberseite der Formmasse (220) angeordnet und mit wenigstens einigen der mehreren Drahtbondfedern (216) elektrisch gekoppelt ist, wobei die mehreren Drahtbondfedern (216), die leitende Schicht (222) und die Grundplatte zusammen die integrierte elektromagnetische Störabschirmung bilden.

2. Verpacktes Halbleitermodul (200) nach Anspruch 1, wobei die mehreren Drahtbondfedern (216) aus Golddraht oder Kupferdraht gebildet sind.

3. Verpacktes Halbleitermodul (200) nach einem vorherigen Anspruch, wobei die leitende Schicht (222) silbergefülltes Epoxid beinhaltet.

4. Verpacktes Halbleitermodul (200) nach einem vorherigen Anspruch, wobei das elektronische Bauelement (202) ein RF-Bauelement ist.

5. Verpacktes Halbleitermodul (200) nach einem vorherigen Anspruch, wobei jede der mehreren Drahtbondfedern (216) so gestaltet ist, dass sie eine Federwirkung bereitstellt, die einen Kontakt zwischen der leitenden Schicht (222) und der Drahtbondfeder (216) zulässt, um die elektrische Kopplung zwischen der leitenden Schicht (222) und der Drahtbondfeder (216) bereitzustellen.

6. Verpacktes Halbleitermodul (200) nach einem vorherigen Anspruch, das ferner einen ersten und einen zweiten metallisierten Verbindungspunkt (214, 210) umfasst, angeordnet auf der Oberfläche des Substrats (204), wobei der Kugelbond (224) mit dem ersten metallisierten Verbindungspunkt (214) gekoppelt ist und das Ende der abfallenden Schweifregion (238) mit dem zweiten metallisierten Verbindungspunkt (210) gekoppelt ist.

7. Verpacktes Halbleitermodul (200) nach Anspruch 1, wobei die mehreren Drahtbondfedern (216) auf dem Substrat (204) um einen Umfang des elektronischen Bauelements (202) positioniert sind.

8. Verfahren zur Herstellung eines Moduls (200) mit einer integrierten elektromagnetischen Störabschirmung, wobei das Verfahren Folgendes beinhaltet:
Verbinden eines elektronischen Bauelements (202) mit einem Substrat (204);
Bereitstellen von Metallisierungen (214, 210) auf dem Substrat (204);
Bilden von mehreren mit den Metallisierungen (214, 210) verbundenen Drahtbondfedern (216), wobei jede Drahtbondfeder (216) durch Absetzen einer Drahtkugel (224) auf die Metallisierungen (214), Bilden einer Drahtschlaufe (226) durch Ziehen von Draht von der Drahtkugel (224) zum Bilden der Drahtschlaufe (226) mit einem mit der Drahtkugel (224) verbundenen ersten Ende, einer Beugungszone (230), einem Scheitelpunkt (232) im Wesentlichen vertikal über der Beugungszone (230), einer konvexen Region (234), die zwischen der Beugungszone (230) und dem Scheitelpunkt (232) verläuft, wobei die Beugungszone (230) zwischen der konvexen Region (234) und dem Kugelbond (224) ist, einer abfallenden Schweifregion (238) mit einem mit den Metallisierungen (210) verbundenen Ende, wobei das genannte Ende der genannten abfallenden Schweifregion das zweite Ende der genannten Drahtschlaufe bildet, und einer im Wesentlichen flachen Region (236), die zwischen dem Scheitelpunkt (232) und der abfallenden Schweifregion (238) verläuft;
Durchführen eines Transfer-Molding-Prozesses, um das elektronische Bauelement (202) in der Formmasse (220) zu verkapseln und um die mehreren Drahtbondfedern (216) wenigstens teilweise mit der Formmasse (220) abzudecken; und
Anordnen einer leitenden Schicht (222) auf einer Oberfläche der Formmasse (220), wobei die leitende Schicht (222) mit wenigstens einigen der mehreren Drahtbondfedern (216) elektrisch verbunden ist.

9. Verfahren nach Anspruch 8, das ferner das Abladieren der Oberfläche der Formmasse (220) vor dem Anordnen der leitenden Schicht (222) auf der Oberfläche der Formmasse (220) beinhaltet, um Regionen von wenigstens einigen der mehreren Drahtbondfedern (216) zu exponieren.

10. Verfahren nach Anspruch 8, wobei das Bereitstellen von Metallisierungen (214, 210) das Bereitstellen einer Grundplatte und wenigstens eines mit der Grundplatte elektrisch verbundenen Drahtbondkontaktbereichs beinhaltet.

11. Verfahren nach Anspruch 8, wobei das Anordnen der leitenden Schicht (222) auf der Oberfläche der Formmasse (220) das Aufstreichen einer Schicht aus silbergefülltem Epoxid auf die Oberfläche der Formmasse (220) beinhaltet.

## Revendications

1. Module semi-conducteur sous boîtier (200) comportant un blindage contre les interférences électromagnétiques intégré, le module semi-conducteur sous boîtier (200) comprenant :
un substrat (204) ayant un plan de masse (212) ;
un dispositif électronique (202) monté sur une surface du substrat (204) ;
une pluralité de ressorts de microcâblage (216) disposée autour du dispositif électronique (202) et couplée électriquement au plan de masse, chacun de la pluralité de ressorts de microcâblage (216) comportant une boucle de fil (226) comportant à une première extrémité une bille de liaison (224) disposée sur la surface du substrat (204), une zone d'inflexion (230), une crête (232) sensiblement verticalement au-dessus de la zone d'inflexion (230), une région convexe (234) s'étendant entre la zone d'inflexion (230) et la crête (232), la zone d'inflexion (230) se trouvant entre la région convexe (234) et la bille de liaison (224), une région de queue penchée (238) comportant une extrémité couplée au substrat (204), l'extrémité de la région de queue penchée formant la seconde extrémité de ladite boucle de fil, et une région sensiblement plate (236) s'étendant entre la crête (232) et la région de queue penchée (238) ;
un composé de soudure (220) recouvrant le dispositif électronique (202) et recouvrant au moins partiellement la pluralité de ressorts de microcâblage (216) ; et
une couche conductrice (222) disposée sur une surface supérieure du composé de soudure (220) et couplée électriquement à au moins certains de la pluralité de ressorts de microcâblage (216), la pluralité de ressorts de microcâblage (216), la couche conductrice (222) et le plan de masse formant ensemble le blindage contre les interférences électromagnétiques intégré.

2. Module semi-conducteur sous boîtier (200) selon la revendication 1 dans lequel la pluralité de ressorts de microcâblage (216) est formée en fil d'or ou fil de cuivre.

3. Module semi-conducteur sous boîtier (200) selon l'une quelconque des revendications précédentes dans lequel la couche conductrice (222) comporte de l'époxy à charge d'argent.

4. Module semi-conducteur sous boîtier (200) selon l'une quelconque des revendications précédentes dans lequel le dispositif électronique (202) est un dispositif RF.

5. Module semi-conducteur sous boîtier (200) selon l'une quelconque des revendications précédentes dans lequel chacun de la pluralité de ressorts de microcâblage (216) est conformé de manière à produire un effet ressort qui permet le contact entre la couche conductrice (222) et le ressort de microcâblage (216) pour assurer le couplage électrique entre la couche conductrice (222) et le ressort de microcâblage (216).

6. Module semi-conducteur sous boîtier (200) selon l'une quelconque des revendications précédentes comprenant en outre des premier et second points de connexion métallisés (214, 210) disposés sur la surface du substrat (204), la bille de liaison (224) étant couplée au premier point de connexion métallisé (214) et l'extrémité de la région de queue penchée (238) étant couplée au second point de connexion métallisé (210).

7. Module semi-conducteur sous boîtier (200) selon la revendication 1 dans lequel la pluralité de ressorts de microcâblage (216) est positionnée sur le substrat (204) autour d'un périmètre du dispositif électronique (202).

8. Procédé de fabrication d'un module (200) comportant un blindage contre les interférences électromagnétiques intégré, le procédé comprenant :
la connexion d'un dispositif électronique (202) à un substrat (204) ;
la fourniture de métallisations (214, 210) sur le substrat (204) ;
la formation d'une pluralité de ressorts de microcâblage (216) connectée aux métallisations (214, 210), chaque ressort de microcâblage (216) étant formé en déposant une bille de fil (224) sur les métallisations (214), formant une boucle de fil (226) en tirant le fil de la bille de fil (224) pour former la boucle de fil (226) ayant une première extrémité connectée à la bille de fil (224), une zone d'inflexion (230), une crête (232) sensiblement verticalement au-dessus de la zone d'inflexion (230), une région convexe (234) s'étendant entre la zone d'inflexion (230) et la crête (232), la zone d'inflexion (230) se trouvant entre la région convexe (234) et la bille de liaison (224), une région de queue penchée (238) comportant une extrémité connectée aux métallisations (210), ladite extrémité de ladite région de queue penchée formant la seconde extrémité de ladite boucle de fil, et une région sensiblement plate (236) s'étendant entre la crête (232) et la région de queue penchée (238) ;
l'exécution d'un processus de soudage par transfert pour encapsuler le dispositif électronique (202) dans ledit composé de soudage (220) et recouvrir au moins partiellement la pluralité de ressorts de microcâblage (216) avec le composé de soudure (220) ; et
le dépôt d'une couche conductrice (222) sur une surface du composé de soudure (220), la couche conductrice (222) étant connectée électriquement à au moins certains de la pluralité de ressorts de microcâblage (216).

9. Procédé selon la revendication 8 comprenant en outre l'ablation de la surface du composé de soudure (220), avant le dépôt de la couche conductrice (222) sur la surface du composé de soudure (220), pour exposer des régions d'au moins certains de la pluralité de ressorts de microcâblage (216).

10. Procédé selon la revendication 8 dans lequel la fourniture des métallisations (214, 210) comporte la fourniture d'un plan de masse et d'au moins une zone de contact de microcâblage connectée électriquement au plan de masse.

11. Procédé selon la revendication 8 dans lequel le dépôt de la couche conductrice (222) sur la surface du composé de soudure (220) comporte la peinture d'une couche d'époxy à charge d'argent sur la surface du composé de soudure (220).
